# EUROPEAN PATENT APPLICATION

(11) **EP 4 672 312 A1**
(43) Date of publication of application: **31.12.2025**
(21) Application number: 24185334.0
(22) Date of filing: 28.06.2024
(51) Int. Cl.: H01L 21/822, H01L 21/8234, H01L 21/8238, H01L 27/06, H01L 27/088, H01L 27/092, H01L 29/417, H01L 29/66, H01L 29/775

(54) **CFET STRUCTURE AND METHOD OF FABRICATING A CFET STRUCTURE**

(71) Applicant: Imec VZW, 3001 Leuven (BE)
(72) Inventor: Boemmels, Juergen, 3001 Heverlee (BE); Hellings, Geert, 1500 Halle (BE); Mirabelli, Gioele, 3000 Leuven (BE)
(74) Representative: Roth, Sebastian

(57) **Abstract**

The disclosure relates to a complementary field effect transistor, CFET, structure (10). The CFET structure (10) comprises: a vertical wall structure (15); first transistor structure (21) comprising one or more first channel layers (11a), and a second transistor structure (22) comprising one or more second channel layers (12a), wherein the second transistor structure (22) is stacked on the first transistor structure (21); wherein the first and the second transistor structure (21, 22) are arranged on one side of the vertical wall structure (15), and wherein the first and the second channel layers (11a, 12a) are in contact with a side surface of the vertical wall structure (15). The vertical wall structure (15) comprises: a conductive core layer (13) and a spacer layer (14) which partially covers the conductive core layer (13) on the side surface of the vertical wall structure (15); wherein the spacer layer (14) has at least one opening to electrically connect the second transistor structure (22) with the conductive core layer (13).

## Description

### TECHNICAL FIELD

The present disclosure refers to a complementary field effect transistor (CFET) structure and to a method of fabricating such a CFET structure.

### BACKGROUND

In a CFET device, different transistors, particularly NMOS and PMOS transistors, maybe stacked on top of each other compared, for example, to a nanosheet device, which comprises NMOS and PMOS transistors arranged side by side with a spacing in-between them. The stacking of the transistors in the CFET device allows for an area scaling (i.e., a reduction of physical dimensions) of up to 50%. However, this area scaling is limited by the requirement to access the stacked transistors, e.g. for providing electrical signals, which decreases the area benefit to circa 30%.

The main issue that limits the scaling in a CFET device is the fact that the top transistor shadows the bottom transistor. This prevents the bottom transistor from being connected to the tracks directly above the CFET device. Instead, all connections to the bottom transistor, e.g. downward power connections or front side connections, are typically realized from zones outside of the active area of the CFET device (outer-zone).

For example, a conventional CFET design may use respective contact structures which are arranged on both sides of the stacked transistors to provide power to the top and the bottom transistor (symmetric CFET). This limits the CFET scaling to a cell height of approximately 4 tracks (with a 1.5 track active width). Thus, only 37% of the CFET area is the active area, whereas 63% is reserved for power and signal routing.

### SUMMARY

Thus, it is an objective to provide an improved CFET structure and an improved method of fabricating a CFET structure. In particular, the above-mentioned disadvantages should be avoided.

The objective is achieved by the embodiments provided in the enclosed independent claims. Advantageous implementations of the embodiments of the disclosure are further defined in the dependent claims.

A first aspect of this disclosure provides a complementary field effect transistor (CFET) structure. The CFET structure comprises a vertical wall structure; a first transistor structure comprising one or more first channel layers, and a second transistor structure comprising one or more second channel layers, wherein the second transistor structure is stacked on the first transistor structure; wherein the first and the second transistor structure are arranged on one side of the vertical wall structure, and wherein the first and the second channel layers are in contact with a side surface of the vertical wall structure. The vertical wall structure comprises: a conductive core layer and a spacer layer which partially covers the conductive core layer on the side surface of the vertical wall structure; wherein the spacer layer has at least one opening to electrically connect the second transistor structure with the conductive core layer.

This allows for significant size reduction of the CFET structure. For instance, the CFET structure can have a forksheet design, wherein the vertical wall structure forms the "backbone" of the forksheet and additionally provides a power supply to the second (top) transistor structure via the conductive core layer. This CFET structure can be "narrower" than a conventional CFET with outer-zone routing.

The first and the second transistor structure can form a CFET cell or a part of a CFET cell. The CFET cell can be a base cell, in particular a double row base cell, of the CFET structure. The CFET cell can form a logic cell or a unit cell of the CFET structure (e.g., an inverter or NAND cell). The CFET cell may comprise further transistor structures or other elements, which could respectively be directly above or beneath the first and second transistor structure.

The CFET structure can be a CFET device or a part or component thereof. The CFET device can comprise a plurality of CFET cells.

Notably, in this disclosure the terms "below" and "above", "bottom" and "top", "front(side)" and "back(side)", or similar terms are to be interpreted relative to each other. In particular, these terms describe opposite sides of the CFET structure, or opposite sides of any element of the CFET structure. The terms may describe a relationship of elements (e.g., transistor structures, signal routing lines, power rails, etc.) of the CFET structure along the direction of stacking of the tiers (or levels) of the CFET structure. The stacking direction may thus align with the arrangement of the two tiers (or even more than two tiers) of the CFET structure. That is, the two or more tiers (or levels), which are arranged above each other, are arranged one after the other along a certain direction (the stacking direction).

A transistor structure in this disclosure may be or may comprise a transistor, for example a field effect transistor (FET), or may be or may comprise a more complex semiconductor-based structure, which functions like a transistor.

In particular, the conductive core layer is an electrically conductive core layer. The conductive core layer in the vertical wall structure can form a side power rail, e.g. a VDD or VSS side power rail, of the CFET structure. The second (top) transistor structure can be supplied with electrical power from this side power rail.

The CFET device can further comprise side routing layers which are arranged on an opposite side of the stacked first and second transistor structure (i.e., on a side which is opposite to the vertical wall structure). The side routing layers can electrically connect the first and the second transistor structure. This may result in an asymmetric CFET design with a cell height of 3.5 tracks.

In an embodiment, the conductive core layer is electrically connected to at least one source and/or drain structure of the second transistor structure through the at least one opening of the spacer layer.

For instance, the source and/or drain structure extends through the at least one opening to contact the conductive core layer, or an additional contact structure is arranged to connect the source and/or drain structure with the conductive core layer through the opening.

In an embodiment, the vertical wall structure extends below the first transistor structure.

In an embodiment, the first transistor structure is an NMOS structure and the second transistor structure is a PMOS structure, or vice versa.

In an embodiment, the CFET structure further comprises: a third transistor structure comprising one or more third channel layers; and a fourth transistor structure comprising one or more fourth channel layers, wherein the fourth transistor structure is stacked on the third transistor structure; wherein the third and the fourth transistor structures are arranged on an opposite side of the vertical wall structure, and wherein the third and the fourth channel layers are in contact with a further side surface of the vertical wall structure.

Thus, the vertical wall structure can form a backbone for two transistor stacks, namely a first transistor stack which comprises the first and second transistor structure and a second transistor stack which comprises the third and fourth transistor structure. The first and the second transistor stack can be arranged on opposite sides of the wall structure resulting in a symmetrical forksheet design.

In an embodiment, the spacer layer covers the further side surface of the vertical wall structure; and the spacer layer has at least one further opening to electrically connect the fourth transistor structure with the conductive core layer. This achieves the advantage that a power rail, which is formed by the conductive layer in the wall structure, can be shared by the transistors on both sides of the vertical wall structure. This allows for an additional size reduction compared to a conventional CFET design.

In an embodiment, the spacer layer is formed from a dielectric material, such as silicon carbonitride (SiCN).

In an embodiment, the CFET structure further comprises at least one backside contact structure which is arranged below the first transistor structure, and which electrically connects the first transistor structure to a power rail. This achieves the advantage that the first (bottom) transistor structure can be efficiently supplied with VDD or VSS power from the bottom. This bottom connection can provide further scaling benefits, as no side power rail is required for supplying the bottom transistor structure.

The CFET structure may comprise at least one further backside contact structure which is arranged below the third transistor structure, and which electrically connects the third transistor structure to the power rail or a further power rail.

A second aspect of this disclosure provides a method of fabricating a complementary field effect transistor (CFET) structure. The method comprises: forming a vertical wall structure; forming a first transistor structure comprising one or more first channel layers, and forming a second transistor structure comprising one or more second channel layers, wherein the second transistor structure is stacked on the first transistor structure; wherein the first and the second transistor structure are arranged on one side of the vertical wall structure, and wherein the first and the second channel layers are in contact with a side surface of the vertical wall structure. The vertical wall structure comprises: a conductive core layer and a spacer layer which partially covers the conductive core layer on the side surface of the vertical wall structure; wherein the spacer layer has at least one opening to electrically connect the second transistor structure with the conductive core layer.

In an embodiment, the conductive core layer is electrically connected to at least one source and/or drain structure of the second transistor structure through the at least one opening of the spacer layer.

In an embodiment, the vertical wall structure is formed by: etching a trench in a substrate which comprises the first and the second channel layers; depositing the spacer layer on the side walls of the trench; and filling the trench with the conductive core layer.

In an embodiment, after depositing the spacer layer in the trench, the trench is first filled with a replacement material layer, wherein said replacement material layer is replaced by the conductive core layer in a later step.

In an embodiment, the at least one opening is etched into the spacer layer prior to depositing the conductive core layer.

After depositing the replacement material layer, a protective top cap can be formed above the replacement material layer (i.e., on the entrance of the trench). If the trench is directly filled with a conductive core layer (i.e., in case of no replacement material layer), the top cap can be formed above the conductive core layer. The replacement material (layer) can be formed by depositing a sacrificial fill material in the trench.

In an embodiment, the method further comprises: forming a respective source and/or drain structure of the first and the second transistor structure; wherein the vertical wall structure is formed: prior to the formation of the source and/or drain structure of the first or of the second transistor structure, or after the formation of the source and/or drain structure of the first or of the second transistor structure.

In an embodiment, the method further comprises: forming a gate structure of the first and/or the second transistor structure using a replacement metal gate (RMG) technique; wherein the vertical wall structure is formed after the formation of the gate structure.

For instance, when the vertical wall structure is formed last (i.e., after gate formation), the conductive core layer can be directly deposited on the spacer layer and no replacement material layer is required.

In an embodiment, the vertical wall structure extends below the first transistor structure.

In an embodiment, the first transistor structure is an NMOS structure and wherein the second transistor structure is a PMOS structure, or vice versa.

In an embodiment, the method further comprises: forming a third transistor structure comprising one or more third channel layers; and forming a fourth transistor structure comprising one or more fourth channel layers, wherein the fourth transistor structure is stacked on the third transistor structure; wherein the third and the fourth transistor structures are arranged on an opposite side of the vertical wall structure, and wherein the third and the fourth channel layers are in contact with a further side surface of the vertical wall structure.

In an embodiment, the spacer layer covers the further side surface of the vertical wall structure; and the spacer layer has at least one further opening to electrically connect the fourth transistor structure with the conductive core layer.

In an embodiment, the spacer layer is formed from a dielectric material, such as silicon carbonitride (SiCN).

In an embodiment, the method further comprises forming at least one backside contact structure which is arranged below the first transistor structure, and which electrically connects the first transistor structure to a power rail.

The CFET structure according to the first aspect of this disclosure can be fabricated by the method according to the second aspect of this disclosure.

### BRIEF DESCRIPTION OF THE DRAWINGS

The above-described aspects and implementations are explained in the following description of embodiments with respect to the enclosed drawings:
- FIG. 1: shows a schematic diagram of a CFET structure according to an embodiment;
- FIGS. 2A-B: show schematic diagrams of a CFET structure according to an embodiment; and
- FIGS. 3A-U: show steps of a method for fabricating a CFET structure according to an embodiment.

### DETAILED DESCRIPTION OF EMBODIMENTS

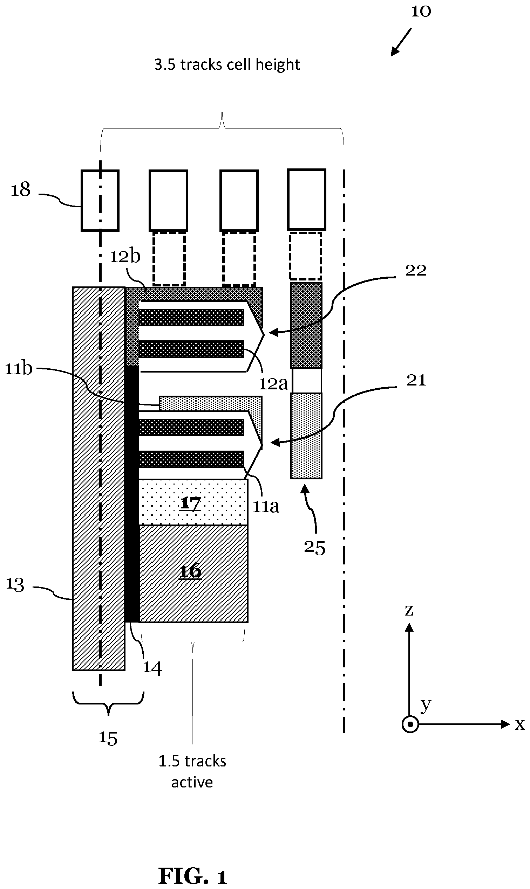

FIG. 1 shows a schematic diagram of a CFET structure 10 according to an embodiment. Thereby, FIG. 1 shows a cross-sectional view through an x-z plane (as indicated by the Cartesian coordinate system), which is perpendicular to a channel direction (y-direction) of the CFET structure 10.

The CFET structure 10 comprises a vertical wall structure 15; a first transistor structure 21 comprising one or more first channel layers 11a, and a second transistor structure 22 comprising one or more second channel layers 12a, wherein the second transistor structure 22 is stacked on the first transistor structure 21; wherein the first and the second transistor structure 21, 22 are arranged on one side of the vertical wall structure 15, and wherein the first and the second channel layers 11a, 12a are in contact with a side surface of the vertical wall structure. The vertical wall structure 15 comprises: a conductive core layer 13 and a spacer layer 14 which partially covers the conductive core layer on the side surface of the vertical wall structure 15; wherein the spacer layer 14 has at least one opening to electrically connect the second transistor structure 22 with the conductive core layer 21.

The z-direction, as indicated by the Cartesian coordinate system in FIG. 1, can be the "stacking direction" of the transistor structures 21, 22 and their elements. For instance, the first transistor structure 21 can be a bottom transistor structure and the second transistor structure 22 can be a top transistor structure of the respective CFET structure 10. In the following, the relative terms "above" and "below" (or "top" and "bottom") indicate a vertical arrangement along the z-direction.

The second transistor structure 22 being stacked on the first transistor structure 21 does not exclude that additional layers (e.g., isolation layers) are arranged between the first and the second transistor structure 22.

The transistor structures 21, 22 can form a CFET cell or a part of a CFET cell. The CFET cell can be a base cell, in particular a double row base cell, of the CFET structure 10. For instance, the CFET cell is a logic cell or a component of a logic cell. The size of the CFET cell and, in particular, the number of its first and second (or bottom and top) transistor structures 21, 22 can depend on its function.

For example, the first (bottom) transistor structure 21 is arranged in a first tier or level of the CFET structure 10 and the second (top) transistor structure 22 is arranged in a second tier or level of the CFET structure 10, above the first tier.

The arrangement of the stacked first and second transistor structures 21, 22 on one side of the vertical wall structure 15 (and in contact with the wall structure 15) results in the CFET structure 10 having a so-called forksheet design, wherein the vertical wall structure 15 forms a "backbone" of this forksheet structure 10.

At least a section of the first and of the second channel layers 11a, 12a can be in physical contact with the spacer layer 14 of the vertical wall structure 15. This contact can be interrupted in area(s) where the spacer layer 14 has the at least one opening. The spacer layer 14 can form or cover the side surface of the vertical wall structure 15 (expect at the location of the openings).

The conductive core layer 13 within the vertical wall structure can provide a power supply to the second transistor structure 15. For this purpose, the conductive core layer 13 can be electrically connected to at least one source and/or drain structure 12b of the second transistor structure 22 through the at least one opening of the spacer layer 14.

For instance, the conductive core layer 13 forms a VSS (or VDD) power rail which is electrically connected to the second transistor structure 22 from the side. Arranging the power supply structure for the second (top) transistor structure 22 in the fork region (i.e., in the backbone structure 15) allows to reduce the cell height of the CFET structure 10. For example, the wall structure 15 and the transistor structures 21, 22 can have a width of circa 3 tracks, wherein the active can maintain a width of 1.5 tracks. Thereby, the tracks can be formed by signaling routing lines 18 which are arranged above the second transistor structure 22 of the CFET elements 10.

The CFET device can further comprise side routing layers 25 which are arranged on a side of the stacked transistor structures 21, 22 that is opposite to the vertical wall structure 15. The side routing layers 25 can electrically connect the first and/or the second transistor structure (e.g., they can be connected to source and/or drain structures 11b, 12b of the first and/or the second transistor structure 21, 22). In this way, the side routing layers 25 can provide routing resources for transmitting electrical signals, e.g., between a top and a bottom transistor structure of the CFET structure 10.

This layout of the CFET structure 10 which uses the forksheet design (i.e. gate edge and active edge are coinciding by process option) on one side of the transistor and side routing layers 25 on the other side may result in an asymmetrical CFET layout with an overall cell height of approximately 3.5 tracks.

The CFET structure 10 can comprise at least one backside contact structure 17 which is arranged below the first transistor structure 21, and which electrically connects the first transistor structure 21 to a further power rail 16. For instance, the power rail 16 can be a VDD power rail.

For example, the first transistor structure 21 is an NMOS structure and the second transistor structure 22 is a PMOS structure, or vice versa.

The vertical wall structure 15 can extend below the first transistor structure 21, as shown in FIG. 1.

The spacer layer 14 can be a dielectric isolation barrier. For instance, the spacer layer can be a silicon carbonitride (SiCN) layer. The conductive core layer 13 can be a metallic layer.

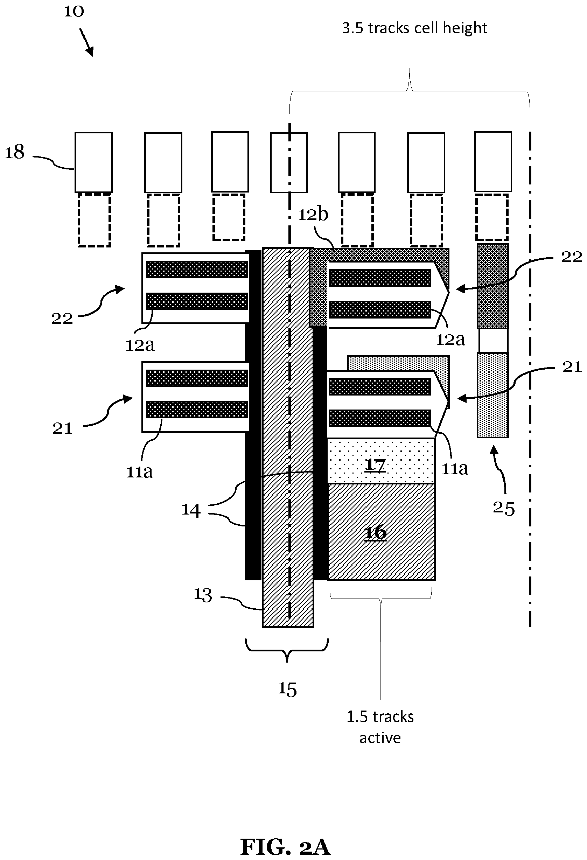

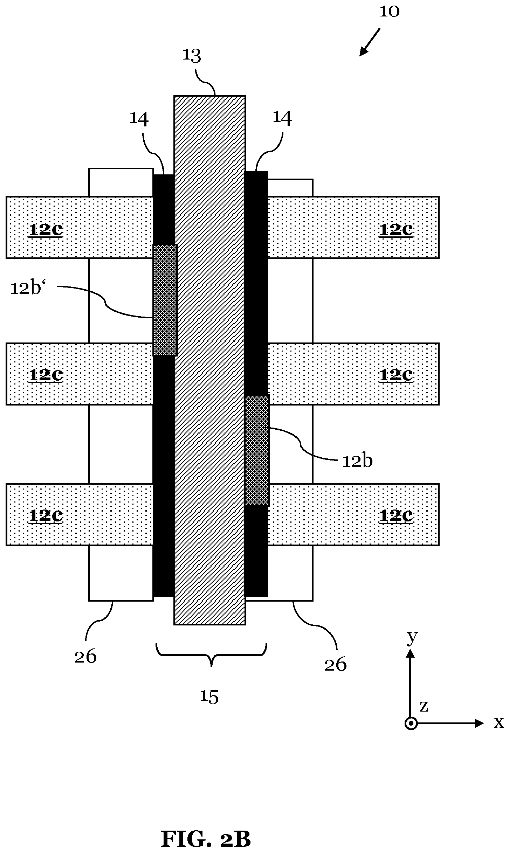

FIGS. 2A and 2B show exemplary embodiments of the CFET structure 10, which build on the CFET structure 10 shown in FIG. 1. Same elements are labelled with the same reference signs. Hereinafter, only the differences between FIG. 1 and FIGS. 2A-2B are explained.

FIG. 2B shows the CFET structure 10 with a further transistor stack being arranged on the opposite side of the vertical wall structure 15 (in FIG. 2B on the left side of the wall structure 15). The further transistor stack comprises a third transistor structure 21 comprising one or more third channel layers 11a, and a fourth transistor structure 22 comprising one or more fourth channel layers 12a, wherein the fourth transistor structure 22 is stacked on the third transistor structure 21. Thereby, the third and the fourth channel layers 11a, 12a are in contact with a further side surface of the vertical wall structure 15.

The transistor structures 21, 22 on the opposite (left) side of the wall structure 15 can form a further CFET cell or a part of a further CFET cell.

The spacer layer 14 can cover the further side surface of the vertical wall structure 15 and can have at least one further opening to electrically connect the fourth (top) transistor structure 22 with the conductive core layer 13.

The CFET cell formed by the first and second transistor structures 21, 22 and the further CFET cell formed by the third and fourth transistor structures 21, 22 can share the power rail which is formed by the conductive core layer 13 in the center. This allows reducing the cell-height of both CFET cells to 3.5 tracks while mostly keeping the active area the same 1.5 tracks.

FIG. 2B shows a top view of the CFET structure 10 from FIG. 2A. As shown in FIG. 2B, the vertical wall structure 15 can extend along the channel direction (the y-direction as indicated by the Cartesian coordinate system). The active area 26 of the top transistor structures 22, which comprises their channel layers 12a, is arranged on both sides of the vertical wall structure 15.

The power rail, which is formed by the conductive core layer 13, can run next (and perpendicular to) to gate structures 12c of the respective transistor structures 21, 22, which allows for a low resistance power connection of the second and fourth (i.e., the top) transistor structures 22.

For sake of simplicity, only the sections of the source and/or drain structures 12b which contact the conductive core layer 13 through the openings in the spacer layer 14 are shown in FIG. 2B. This contact could also be realized by additional contact structures which are arranged to connect the source and/or drain structures of the top transistor structures 22 with the conductive core layer through the openings in the spacer layer 14.

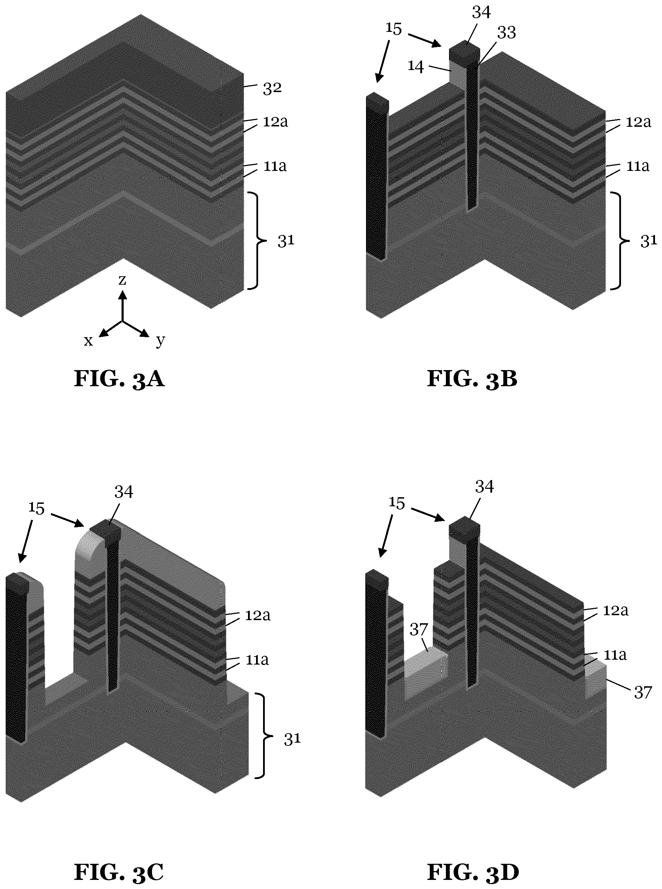

FIGS. 3A-U show steps of a method for processing the CFET structure 10 according to an embodiment. FIGS. 3A-U thereby show section views which indicate a crosssection through an x-z plane and a y-z plane (as indicated by the Cartesian coordinate system).

The method comprises forming a first transistor structure having one or more first channel layers 11a and forming a second transistor structure having one or more second channel layers 12a. The channel layers 11a, 12a can be formed by depositing a grating (e.g., a layer stack) on a substrate 31, as shown in FIG. 1. For instance, the grating comprises alternating layers of a first material (e.g., SiGe15%) and a second material (e.g., Si), wherein the second material layers from the channel layers 11a, 12a. Furthermore, one or multiple middle dielectric isolation (MDI) layers can be formed between the top and bottom channel layers 12a, 11a.

The substrate 31 can be a silicon substrate or a silicon-on-insulator (SOI) substrate. A top layer 32, e.g. a dielectric layer, can be arranged above the grating and a further layer, e.g. a stopping layer, can be arranged below the grating.

In a subsequent step, shown in FIG. 3B, the vertical wall structure 15 is formed. The vertical wall structure 15 can be formed by: etching a trench in the grating which comprises the first and the second channel layers 11a, 12a, depositing the spacer layer 14 on the side walls of the trench; and subsequently filling the trench with a sacrificial fill material 33 (also referred to as: replacement material or replacement material layer). The sacrificial fill material 33 can be replaced by the conductive core layer 13 in a later step.

Furthermore, a top cap 34 can be formed on the wall structure 15. The top cap 34 can be configured to protect the materials of the wall structure 15 during subsequent processing steps and can survive several etch and polish steps. The spacer layer 14 is also configured to resist several isotropic etch steps, such as the spacer removal. For instance, the spacer layer material can be SiCN.

As an alternative to using the sacrificial fill material 33, the trench could be filled directly with the conductive core layer 13 in this step.

In a subsequent step, shown in Fig. 3C, a patterning of the nanosheet (i.e., the grating) can be carried out (active patterning). The pattering can be carried out spacer-defined which allows for lower width variations (e.g., the resulting width of the nanosheet layers stack on both sides of the wall structure 15 can have a higher accuracy due to the spacer layer 14). The resulting shallow trench isolation (STI) can be shallower than the power wall structure 15. Then, as shown in FIG. 3D, a dielectric material 37 can be deposited in the STI.

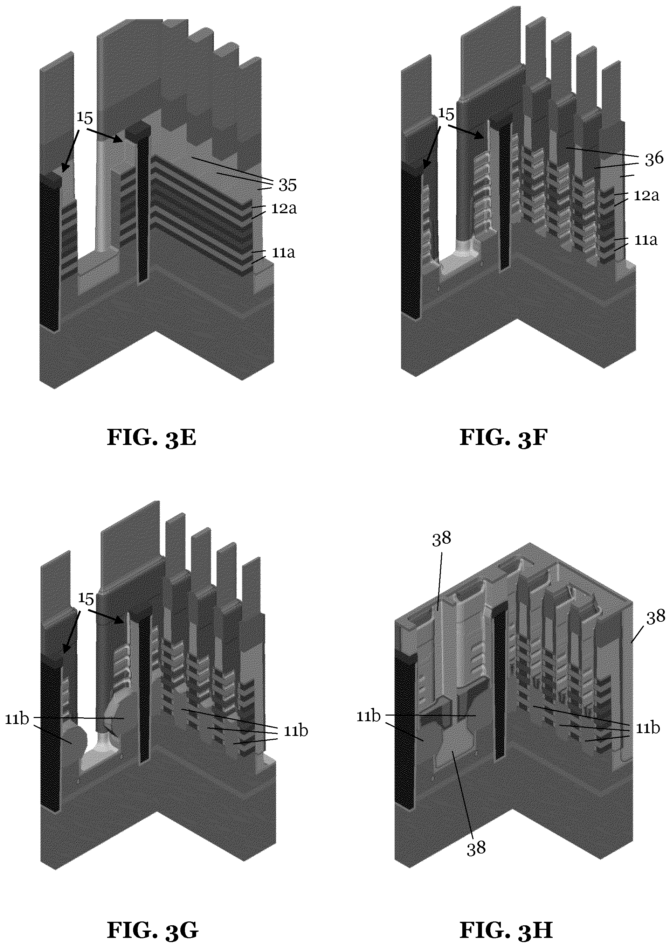

FIG. 3E shows a subsequent dummy gate pattering step. Thereby, a dummy gate material 35 is deposited on the grating (i.e., nanosheet layer stack). The height of the dummy gate can be identical to the height of the vertical wall structure 15.

Then, as shown in FIGS. 3F-G, a conventional CFET/nanosheet process can be carried out to. For instance, a middle dielectric isolation (MDI) and inner spacers 36 are formed, and a spacer/active recess (also called: S/D recess) is carried out (FIG. 3F). Then, bottom source and/or drain structures 11b (i.e., source and/or drain structures of the bottom transistor structure 21) can be formed (FIG. 3G). The source and/or drain (S/D) structures 11b can be formed by an epitaxial growth process. During the bottom S/D formation, the top channels 12a can be covered by a cover spacer.

Subsequently, as shown in Fig. 3H, a metal zero (Mo) material 38 patterning can be carried out. The Mo material 38 can be multipatterned as scaled dimensions may be beyond the single print limit. A self-alignment of the Mo material to the gate may enable a lower mask-count. For instance, the Mo material 38 can be identical to the VSS rail material. After the Mo metallization a recess can be carried out.

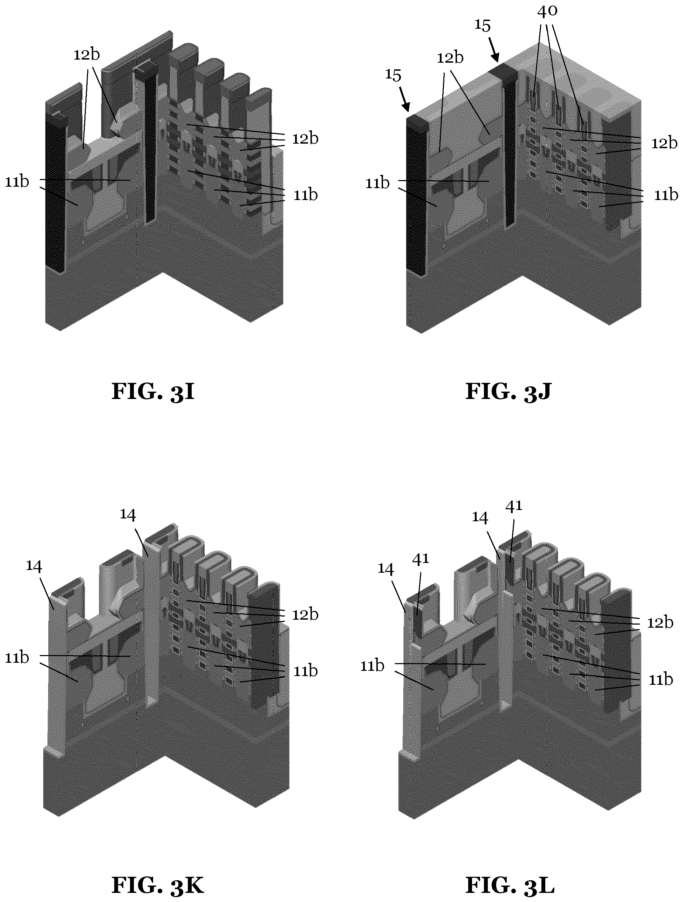

Then, as shown in FIG. 3I, an isolation layer can be formed and top source and/or drain structures 12b can be deposited, e.g. via an epitaxial growth process.

In a subsequent step, a replacement metal gate (RMG) process can be carried out (FIG. 3J). Thereby, the previously generated dummy gate 35 can be replaced by a metal gate 40 structure. A single diffusion break with active cutting can be part of this process.

Subsequently, the vertical wall structure 15 can be opened by removing the top cap 34 and the sacrificial fill material 33 (FIG. 3K). The spacer layer 14 remains intact during this step.

Then, as shown in FIG. 3L, openings 41 are etched into the spacer layer 14. The openings 41 can be generated in areas where the top transistor structure(s) 22, in particular their S/D structures 12b, require a power connection.

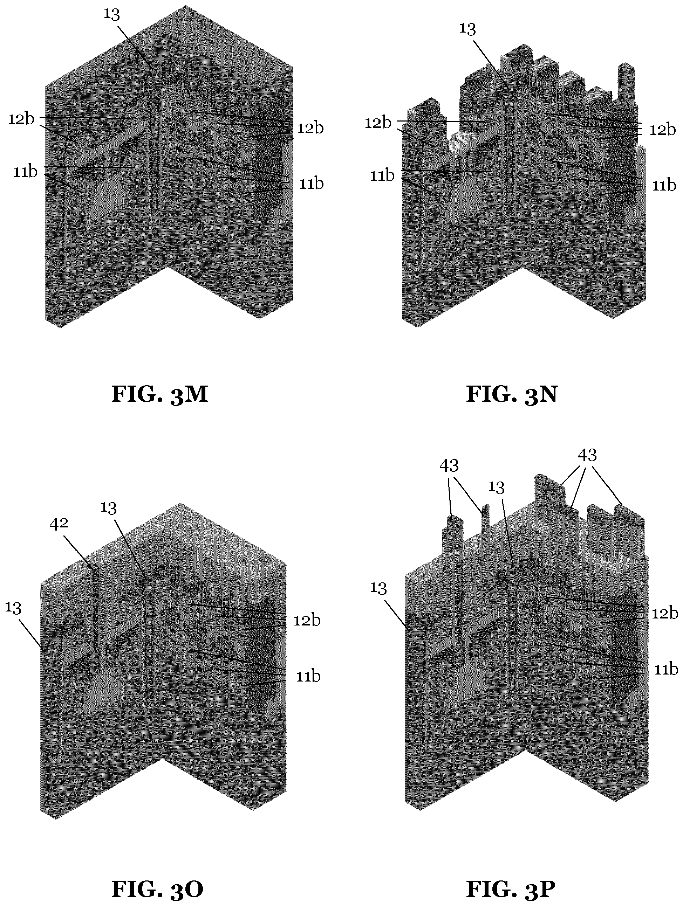

Subsequently, as shown in FIG. 3M, an optional contact etch stop layer (CESL) removal and a subsequent metallization can be carried out. In this way, the vertical wall structure can be filled with the conductive core layer 13 and the electrical connections (e.g., metal-Si contact) between the core layer 13 and top S/D structure(s) 12a through the openings 41 can be realized. Except at these openings 41, the spacer layer 14 covers the conductive core layer 13 on the side surfaces of the vertical wall structure 15.

With the above steps, a CFET structure which comprises stacked first and second transistor structures having first respectively second channel layers 11a, 12a can be fabricated, wherein the first and the second channel layers 11a, 12a are in contact with a side surface of the vertical wall structure 15, and wherein the spacer layer 14 has at least one opening 41 to electrically connect the second transistor structure with the conductive core layer 13 within the wall structure 15. Thereby, the conductive core layer 13 can be electrically connected to at least one S/D structure 12a of the second (top) transistor structure through the at least one opening 41.

FIGS. 3N-U show exemplary steps for further processing this CFET structure.

After the deposition of the conductive core layer material 13, a top metal patterning can be carried out via a direct metal etch (FIG. 3N). Therefore, multiple masks may be required because similar design rules as for a bottom metallization can be used. A damascene approach for the top metallization is also possible.

Subsequently, top side vias 42 can be formed (FIG. 3O). The top side vias 42 can be connected to a bottom metallization, a top metallization and/or gate structures. The top side vias can be formed from either single damascene metal filled or just from holes. Then, as shown in FIG. 3P, BEOL (back end of line) layers 43 can be formed in the vias. The example shown in FIGS. 3O-P shows a first metal layer with direct metal etch, which is advantageous for scaling. Damascene BEOL (more conventional option) is also possible with larger dimensions (e.g., >24 nm pitch).

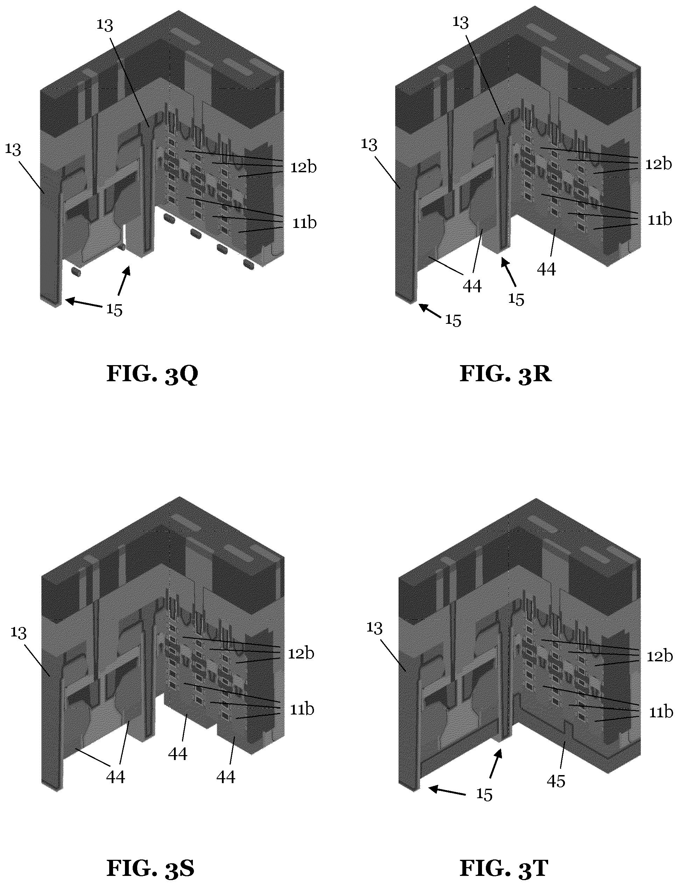

Then, the backside silicon can be removed, as shown in FIG. 3Q. A stop layer can be used to mitigate unwanted variations. While most of the silicon can be removed, the bottom S/D structure (e.g., SiGe) can stay intact. The backside etching is preferably selective to the gate oxide and the spacer layer 14.

Subsequently, a backside isolation can be carried out (FIG. 3R). Therefore, a backside oxide 44 filling can be performed, followed by a CMP and an oxide etch back step. The CMP preferably stops on the spacer layer 14. Then, the backside isolation can be etched in the source and/or drain regions where a power connection is needed (FIG. 3S).

In a subsequent step, shown in FIG. 3T, a backside power metallization 45 can be carried out, followed by a recess. The recess below the vertical wall structure 15 (also referred to as: power wall) together with the merging of neighboring bottom rails can reduce the overlay requirements for additional vias.

The backside metallization 45 can form the backside contact structure 17 (as e.g. shown in FIGS. 1 and 2A) which is arranged below the first transistor structure 21, and which electrically connects the first transistor structure 21 to the further power rail 16.

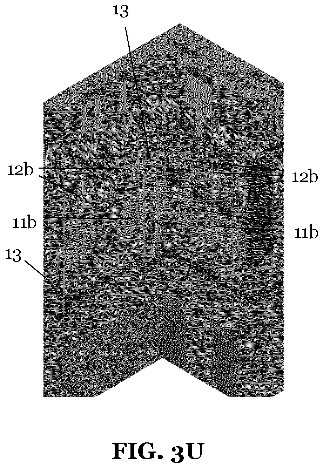

Fig. 3U shows the connection of the backside metallization 45 with BEOL vias (vias not visible in the cross-sectional view of FIG. 3U).

In the exemplary process flow shown in FIGS. 3A-U, the vertical wall structure 15 is formed prior to the formation of any source and/or drain structures 11b, 12b and gate structures. Thereby, a sacrificial fill material 33 may first be deposited in the wall structure 15 and later replaced by the conductive core layer 13. This sequence can be referred to as "wall first" approach.

Alternatively, the vertical wall structure 15 could be formed after the formation of the source and/or drain structures 11a, 12a and before the RMG process ("wall middle" approach).

In a further alternative, the vertical wall structure 15 could be formed after forming the gate structure via RMG ("wall last" approach).

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A complementary field effect transistor, CFET, structure (10), comprising:
a vertical wall structure (15);
a first transistor structure (21) comprising one or more first channel layers (11a), and
a second transistor structure (22) comprising one or more second channel layers (12a), wherein the second transistor structure (22) is stacked on the first transistor structure (21);
wherein the first and the second transistor structure (21, 22) are arranged on one side of the vertical wall structure (15), and wherein the first and the second channel layers (11a, 12a) are in contact with a side surface of the vertical wall structure (15);
wherein the vertical wall structure (15) comprises:
- a conductive core layer (13) and
- a spacer layer (14) which partially covers the conductive core layer (13) on the side surface of the vertical wall structure (15);
wherein the spacer layer (14) has at least one opening to electrically connect the second transistor structure (22) with the conductive core layer (13).

2. The CFET structure (10) of claim 1,
wherein the conductive core layer (13) is electrically connected to at least one source and/or drain structure (12b) of the second transistor structure (22) through the at least one opening of the spacer layer (14).

3. The CFET structure (10) of claim 1 or 2,
wherein the vertical wall structure (15) extends below the first transistor structure (21).

4. The CFET structure (10) of any one of the preceding claims,
wherein the first transistor structure (21) is an NMOS structure and wherein the second transistor structure (22) is a PMOS structure, or vice versa.

5. The CFET structure (10) of any one of the preceding claims, comprising:
a third transistor structure (21) comprising one or more third channel layers (11a); and
a fourth transistor structure (22) comprising one or more fourth channel layers (12a), wherein the fourth transistor structure (22) is stacked on the third transistor structure (21);
wherein the third and the fourth transistor structures (21, 22) are arranged on an opposite side of the vertical wall structure (15), and wherein the third and the fourth channel layers (11a, 12a) are in contact with a further side surface of the vertical wall structure (15).

6. The CFET structure (10) of claim 5,
wherein the spacer layer (14) covers the further side surface of the vertical wall structure (15); and
wherein the spacer layer (14) has at least one further opening to electrically connect the fourth transistor structure (22) with the conductive core layer (13).

7. The CFET structure (10) of any one of the preceding claims,
wherein the spacer layer (14) is formed from a dielectric material, such as silicon carbonitride, SiCN.

8. The CFET structure (10) of any one of the preceding claims, further comprising:
at least one backside contact structure (17) which is arranged below the first transistor structure (21), and which electrically connects the first transistor structure (21) to a power rail (16).

9. A method of fabricating a complementary field effect transistor, CFET, structure (10), comprising:
forming a vertical wall structure (15);
forming a first transistor structure (21) comprising one or more first channel layers (11a), and
forming a second transistor structure (22) comprising one or more second channel layers (12a), wherein the second transistor structure (22) is stacked on the first transistor structure (21);
wherein the first and the second transistor structure (21, 22) are arranged on one side of the vertical wall structure (15), and wherein the first and the second channel layers (11a, 12a) are in contact with a side surface of the vertical wall structure (15);
wherein the vertical wall structure (15) comprises:
- a conductive core layer (13) and
- a spacer layer (14) which partially covers the conductive core layer (13) on the side surface of the vertical wall structure (15);
wherein the spacer layer (14) has at least one opening to electrically connect the second transistor structure (22) with the conductive core layer (13).

10. The method of claim 9,
wherein the conductive core layer (13) is electrically connected to at least one source and/or drain structure (12b) of the second transistor structure (22) through the at least one opening of the spacer layer (14).

11. The method of claim 9 or 10,
wherein the vertical wall structure (15) is formed by:
etching a trench in a substrate which comprises the first and the second channel layers (11a, 12a);
depositing the spacer layer (14) on the side walls of the trench; and
filling the trench with the conductive core layer (13).

12. The method of claim 11,
wherein after depositing the spacer layer (14) in the trench, the trench is first filled with a replacement material layer, wherein said replacement material layer is replaced by the conductive core layer (13) in a later step.

13. The method of claim 11 or 12,
wherein the at least one opening is etched into the spacer layer (14) prior to depositing the conductive core layer (13).

14. The method of any one of claims 9 to 13, further comprising:
forming a respective source and/or drain structure (11b, 12b) of the first and the second transistor structure (22);
wherein the vertical wall structure (15) is formed:
- prior to the formation of the source and/or drain structure (11b, 12b) of the first or of the second transistor structure (22), or
- after the formation of the source and/or drain structure (11b, 12b) of the first or of the second transistor structure (22).

15. The method of any one of claims 9 to 14, further comprising:
forming a gate structure (12c) of the first and/or the second transistor structure (22) using a replacement metal gate, RMG, technique;
wherein the vertical wall structure (15) is formed after the formation of the gate structure (12c).
